# EUROPEAN PATENT APPLICATION

(11) **EP 1 754 799 A2**
(43) Date of publication of application: **21.02.2007**
(21) Application number: 06117775.4
(22) Date of filing: 25.07.2006
(51) Int. Cl.: C23C 14/24

(54) **Method for manufacturing of storage phosphor plates.**

(30) Priority: 12.08.2005 EP 05107431; 12.08.2005 EP 05107432; 12.08.2005 EP 05107433; 12.08.2005 EP 05107434
(71) Applicant: AGFA-GEVAERT, 2640 Mortsel (BE)
(72) Inventor: Tahon, Jean-Pierre AGFA-GEVAERT, 2640, Mortsel (BE); Aerts, Bart AGFA-GEVAERT, 2610, Mortsel (BE); Cabes, Thomas AGFA-GEVAERT, 2640, Mortsel (BE); Lamotte, Johan AGFA-GEVAERT, 2640, Mortsel (BE); Leblans, Paul AGFA-GEVAERT, 2640, Mortsel (BE)

(57) **Abstract**

In a method of consecutively manufacturing a set of at least 5 storage phosphor plates by a vapor deposition process in one and the same vapor deposition apparatus, in said apparatus, before starting each vaporization, refractory material surfaces are brought into contact, in a crucible unit thereof, with liquefied raw materials of a matrix component and an activator component, a phosphor precursor component or a combination thereof, wherein deviations in speed from one plate to another within said set of storage phosphor plates are less than 15 %, said deviations being expressed as a variation coefficient defined by following formula (SAL%dev/SAL%av) x 100, provided that SAL%av stands for an averaged speed within average speeds over each of said storage phosphor plate surfaces within said set and that SAL%dev stands for a standard deviation of averaged speeds obtained from each phosphor plate within said set, wherein a step of increasing said refractory material surfaces is included by adding to said crucible unit, before starting vaporization in the manufacturing of each of said plates in said set, refractory particles selected from the group consisting of a powder, crystalline particles, amorphous particles, spheres, bars, sticks, ingots and curls or a combination thereof.

## Description

### FIELD OF THE INVENTION

The present invention relates to a repeatedly performed vapor depositing process of raw materials by depositing said raw materials in vaporized form while heating under reduced pressure in a vapor deposition apparatus, leading to increased reproducibility, a better control, a higher sensitivity or speed, and less deviation thereupon in a series production of particularly preferred needle image storage phosphor plates or panels and wherein said plates or panels are suitable for use in computed radiography.

### BACKGROUND OF THE INVENTION

It is known to prepare a phosphor or scintillator layer by a vapor deposition method in order to get a phosphor or scintillator deposited onto a substrate or support without a binder. In that method starting raw materials, present as evaporation sources, are heated and vaporized in order to become deposited from the vapor in order to form a phosphor or scintillator layer on the surface of the substrate. Thus formed phosphor or scintillator screens, plates or panels essentially consist of block-shaped, prismatic or needle-shaped crystal layers with cracks in between as has e.g. been shown in the MORCHAN-DEMCHISKIN diagram in Fig. 8 from US-A 5,427,817. Dimensions of said crystals and cracks in between, and, consequently, layer densities of scintillators and phosphors are depending on substrate temperature and inert gas pressure. It is expected that a phosphor layer formed by deposition has lower amounts of impurities because it is formed in vacuum, as it contains substantially no binder and as no components other than those constituting the envisaged scintillator or phosphor are present. Improved characteristics as smaller variation in performance and high luminescence efficiency can thus be expected, when starting evaporation from basic raw materials, usually called main or parent component and an activator component respectively. Vapor deposition can start from one source, wherein a mixture is present from said basic parent and activator components, or a precursor from previously reacted basic parent and activator components. Alternatively vapor deposition can start from a multiple source deposition if it is believed to take more advantage while independently controlling heating of each of a main or parent basic raw material besides an activator raw material or besides a precursor raw material or combinations thereof. In US-A 6,802,991 the preparation of a phosphor layer of stimulable CsX:Eu phosphor, produced by vapor deposition, has been described. In US-A 2001/0007352 needle-shaped long and thin columnar crystals having a well-defined crystallinity have been described, wherein pictures of the most desired CsBr:Eu phosphor have been shown. As it may be supposed that the columnar form prevents traverse diffusion of stimulated emission light (or photo-stimulated luminescence), i.e., that light reaches the support surface with repeating reflection at the interface of cracks or columnar crystals, a markedly enhanced sharpness of images formed by the stimulated luminescence can be expected. Superiority of a radiation image conversion system employing radiation image conversion panels provided with CsBr:Eu is greatly dependent however on stimulated emission luminance (expressing sensitivity or speed) and sharpness of the obtained image, which are known to be affected by specific characteristics of the stimulable phosphor, but also from the homogeneity of those characteristics over the whole panel surface. Said characteristics more particularly depend on the vapor deposition process as performed in a vapor deposition apparatus with crucibles having particular properties, mounted therein.

So in US-A 2005/0000447 a crucible with reduced cross-section for raw material evaporation for use in a vapor deposition process has been presented. Such a crucible having a bottom and surrounding side walls provided with electrode clamps at exterior sites of side walls located opposite with respect to each other, wherein said sites are extending as lips at said side walls, and wherein said clamps are connectable with electrodes for heating said crucible, is e.g. characterized by a cross-section of each of said lips between between crucible wall and electrode clamp which is reduced with at least 5 %, by providing each lip with perforations.

Further in US-A 2005/0000411 an assembly comprising a crucible, provided with two plates or covers is presented, wherein one thereof is an outermost plate or cover provided with a perforation pattern, selected from the group consisting of one or more slits, in series or in parallel, and of openings having same or different diameter, randomly or regularly distributed over said cover, moreover covering said crucible having a bottom and surrounding side walls with a height "h" and wherein said crucible contains raw materials, is characterized in that a second plate is mounted internally in the crucible at a distance from said outermost cover plate of less than 2/3 of said height "h".

Furtheron in unpublished EP-Application No. 03102004, filed July 4, 2003, an assembly comprising two plates or covers has been proposed, one of which being an outermost plate or cover, and both, at least in part having a perforation pattern over a surface area covering an open side of a crucible having a bottom and surrounding side walls containing raw materials, wherein said outermost cover is mounted at a distance farther from said crucible than said cover covering the open side of said crucible, and wherein both covers are mounted versus each other, so that, when viewed through an axis in a direction perpendicular to the bottom of the crucible from a distance to said outermost cover of at least 10 times the distance between said two plates or covers, its contents cannot be observed as perforations and the crucible bottom are never forming one line, perpendicular to the plane formed by said bottom.

More particular configurations of a vacuum deposition apparatus, designed for continuously, on line deposition has been described in US-A 2004/0224084, wherein a method for coating a phosphor or a scintillator layer onto a flexible substrate within a sealed zone maintained under vacuum conditions by the step of vapor deposition has been described, wherein said phosphor or scintillator layer is deposited onto said substrate and wherein said substrate is deformed at least before, during or after said step of vapor deposition.

Furtheron in US-A 2005/0000448 a method for preparing a plurality of phosphor or scintillator sheets or panels is disclosed, wherein said sheets or panels have flexible supports or substrates by coating a phosphor or scintillator layer within a sealed zone, wherein said zone comprises at least two cylindrical carrier rollers for carrying a flexible substrate exceeding dimensional formats of desired phosphor or scintillator sheets or panels with a factor of at least 5, wherein said cylindrical carrier rollers each have an axis in a parallel arrangement with one another; wherein said zone comprises at least one crucible containing a mixture of raw materials providing desired phosphor or scintillator compositions for said layer; and wherein said zone comprises a laminating unit.

Until now attempts to get an improved homogeneity have been performed starting from the starting raw materials used in the vapor deposition process at one side, and from improvements in the vapor deposition crucible. So, whether or not deposited on line on a large support or on a support mounted on a rotating disc in the vicinity of a vapor deposition crucible, it remains of utmost importance, not only to increase speed of the storage or photostimulable phosphor thus obtained, but also to get a homogeneous speed and image quality over the whole plate and a better control thereof. Attempts to improve both factors have until now been described in US-A's 2005/181119, 2005/186329, 2005/184271 and 2006/076525.

Whereas the first three US-Applications are related with the use of dedicated mixtures of precursor raw materials in order to prepare storage phosphors wherein a more homogeneously divided Eu activator is leading to an improved speed, in the last application addition of well-defined amounts of rubidium halide and cesium chloride in said matrix, and, optionally, further presence of alkali metal, alkaline earth metal and/or metal earth salts, and/or, optionally, other metal salts or oxides, provides a remarkable speed increase, without loss in sharpness and provides an image storage screen or panel, suitable for use in applications related with computed radiography wherein, on a support, a binderless needle-shaped stimulable CsBr:Eu phosphor layer is present having low amounts of a europium activator or dopant in favour of homogeneous distribution of said Europium activator in the CsBr matrix.

However it remains an ever lasting demand to get a homogeneous activator distribution over the needles in the needle-shaped storage phoshor layer, but also over the whole storage phosphor plate, further offering the highest speed possible, without negatively influencing image quality, and, more in particular, sharpness or image definition. Moreover the problem becomes still more stringent if a series of plates or panels should be prepared consecutively. As refractory materials are quite expensive it is of utmost importance, in favour of a cost efficient preparation thereof to recover those refractory materials. When making use of the same vapor deposition apparatus with the same, recovered refractory materials for consecutively preparing a series of phosphor plates or panels it is of utmost importance to get a series of phosphor plates or panels having reproducible characteristics from a point of view of sensitivity or speed, as well as a point of view of image quality.

### OBJECTS AND SUMMARY OF THE INVENTION

It is an object of the present invention to provide a reproducible method of preparing a storage phosphor plate or panel having an increased screen speed without negatively influencing image quality.

More in particular it is an object to provide a method in order to get a reproducible series of plates or panels that have been prepared in the same vapor deposition apparatus.

Further objects attained by application of the method of the present invention will become apparent from the description and comments added to the examples hereinafter.

The above-mentioned advantageous objectives have been realized by providing a process for the preparation of a radiographic image storage panel, more in particular by vapor deposition of a storage phosphor layer onto a suitable substrate or support, while vapor depositing said storage phosphors from raw materials initially present in a refractory crucible or combinations of crucibles having the specific features as set out in claim 1. Specific features for preferred embodiments of the invention are set out in the dependent claims.

Further advantages and embodiments of the present invention will become apparent from the following description and drawing(s).

### BRIEF DESCRIPTION OF THE DRAWINGS

Fig.1 shows a view of a crucible with an indication of the significance of dimensions as "width 'W' ", "height 'H' " and "length 'L'", wherein (1) represents a folded crucible; (2) the container of the crucible, (3) a lip (present at both sides of the crucible), (4) a cover plate with (5) a slit therein, wherein guiding plate (6), further directs the vapor stream towards a substrate. It is clear that width 'W' is always less than length 'L'.
Fig.2 shows a side view (cut through position A from Fig. 1)
Fig.3 shows a front view (cut through position B from Fig. 1)
Fig.4 shows a side view (cut through position A) for a crucible configuration with internally positioned, folded cover plate (7).
Fig. 5 shows a front view (cut through position B) for the same crucible configuration as in Fig. 4, with internally positioned the same folded cover plate (7) and moreover an indication of the level indicated by arrow H' [see indications with (8) and (8') at both sides of the crucible after liquefying raw materials up to the levels (8) and (8')], attained when filling the crucible with said raw materials.

### DEFINITIONS

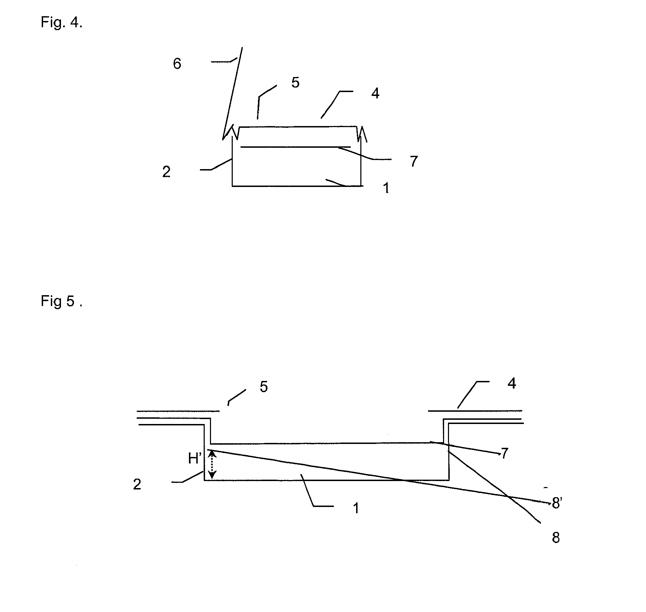

- A "crucible unit" is a configuration wherein, besides a boat or crucible as an essential part to contain "raw materials", all extended parts built up from a refractory material coming into contact with liquefied and/or vaporized raw materials are included. As extended parts an optionally present chimney, one or more covers (whether or not perforated or provided with slits), one or more baffle plate(s), shielding or heat-protecting screen(s), flap(s), additional refractory material parts coming into contact with vaporized and/or liquefied raw materials and additional parts present within said vapor deposition apparatus coming into contact with vaporized raw materials should be considered. Examples of such additional parts are e.g. thermocouples, required to control local temperatures within a vapor depositing apparatus, when covered with refractory metal material, besides optionally present cooling and/or heating units steering temperature within the vapor deposition apparatus when made in refractory materials. Excluded however are the substrate or support whereupon the phosphor should be deposited and the walls of the vapor deposition apparatus. It is clear that the inner surface part within a crucible or boat acting as a container for said "raw materials" in the liquid or molten state and having contact therewith in that state is varying throughout the vapor deposition process as raw materials escape from the crucible(s) in vaporized form, in order to become deposited onto the (cooled) support. "Part of the inner surface" is thus defined as the surface part of the refractory material within the crucible acting as a container for the "raw materials" in the liquid state and having contact therewith in that state, "coming into contact with liquefied raw materials in molten state, just before getting evaporated". Raw materials become evaporated through heating under reduced pressure within the vapor deposition apparatus.
- "raw materials" are starting products or starting components, present as phosphor precursors, at least comprising a matrix component and an activator component. Said precursors are used for preparing phosphors thereof by evaporation in a vapor depositing step, once enough energy is added in order to start vaporization of main, parent or matrix component(s), such as pure alkali halide salt(s) at one side, and pure activator salts, present as oxides, halides and/or oxy halides, as well as particular precursors (having a composition wherein main component and activator are already present as at least one composition thereof) or combinations. Said raw materials are normally added to a crucible container in a solid state and are liquefied by heating before starting the vaporization process.
- "refractory" expresses "resisting treatment under ordinary or various extraordinary conditions, such as capability of enduring or resisting high temperature" as in the context of the present invention.
- A "crucible" is a construction in form of a "boat" as an essential part having as dimensions a width 'w', a height 'h' and a length '1'. The surface of the refractory material within the crucible or boat acts as a container for the "raw materials" in the liquid or molten state, and has contact therewith in that state, wherein said surface is varying throughout the vapor deposition process as that process is proceeding. Part of the refractory material not contacting liquefied raw materials is struck with vaporized raw material.
- "Reactive crucible ratio RCR" is the figure, expressing the ratio of the extended refractory material surface "ERMS" of one or more crucible unit(s) present in a vapor deposition apparatus coming into contact with liquefied raw materials present in one or more crucible unit(s) and/or coming into contact with one or more vapor cloud(s) from said "raw materials" (defined above) escaping from one or more crucible unit(s) at one side, and part of crucible surface(s) of said crucible, defined as part of inner crucible surface contacting liquefied "raw materials" before starting evaporation of said "raw materials", at the other side.
- "Extended refractory material surface ERMS" is defined as the sum of all of the surfaces of extended parts made in refractory material(s), present in one or more crucible unit(s) in a vapor deposition apparatus as mentioned above in the definition of said "crucible unit". The extended refractory material surface together with the surface(s) of the crucible(s), defined as boat(s) or container(s) for the "raw materials" defined hereinafter, represent the total - inner and outermost - surface(s) of said crucible unit(s).
- The "reactive crucible ratio RCR" is defined as the ratio of "extended refractory material surface ERMS" and "part of inner crucible surface contacting liquid raw materials (just) before starting evaporation".
- The "internal reactive crucible ratio IRCR" is the figure, expressing the ratio of the internally added refractory material surface added to one or more boat(s) or crucible(s), present in a vapor deposition apparatus coming into contact with liquefied raw materials present in one or more crucible(s) and partial crucible surface(s) of said crucible, defined as inner part of said crucible contacting liquefied "raw materials" before starting evaporation of said "raw materials".
- Refractory Crucible Surface Ratio "RCSR" expresses a ratio of refractory material crucible surfaces contacting liquefied raw materials in a crucible container before starting vaporization (see e.g. up to height H' - levels 8-8' in Fig. 5 - and global refractory material crucible surfaces contacting vapor clouds of vaporised raw materials while vapor depositing proceeds, i.e. the sum of all of the surfaces of
   1) part of the refractory inner surface of the crucible contacting vaporised raw materials while vaporizing them;
   2) the total refractory outer surface of the crucible;
   3) the total refractory inner and outer surface of the internally positioned folded refractory plate (7)
   4) the total refractory inner and outer surface of the first (not internal) cover plate (4).

Excluded from global refractory crucible surfaces are all extended surfaces, as e.g. additional covers and guiding plate (6), as well as all refractory material surfaces not contacting the crucible as e.g. baffles and thermocouples covered with refractory metals.

It is clear that all of the surfaces should be expressed in the same square units, more particularly when ratios of surfaces should be calculated. In the present invention all surfaces will e.g. further be expressed in cm².

### DETAILED DESCRIPTION OF THE INVENTION

In the present invention, in a method of consecutively manufacturing a set of at least 5 storage phosphor plates by a vapor deposition process in one and the same vapor deposition apparatus, in said apparatus, before starting each vaporization, refractory material surfaces are brought into contact, in a crucible unit thereof, with liquefied raw materials of a matrix component and an activator component, a phosphor precursor component or a combination of matrix, activator and precursor component, wherein deviations in speed from one plate to another within said set of storage phosphor plates are less than 15 %, said deviations being expressed as a variation coefficient defined by following formula (SAL%dev/SAL%av) x 100, provided that SAL%av stands for an averaged speed within average speeds over each of said storage phosphor plate surfaces within said set and that SAL%dev stands for a standard deviation of averaged speeds obtained from each phosphor plate within said set, wherein a step of increasing said refractory material surfaces is included by adding to said crucible unit, before starting vaporization in the manufacturing of each of said plates in said set, refractory particles selected from the group consisting of a powder, crystalline particles, amorphous particles, spheres, bars, sticks, ingots and curls or a combination thereof.

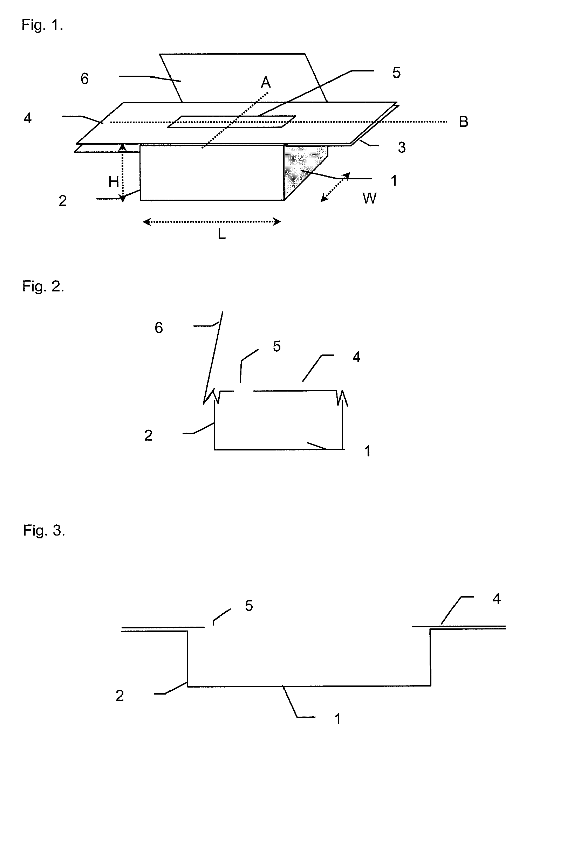

Besides the refractory materials composing the crucible(s) within the vapor deposition apparatus, extra refractory or heat-resistant material surfaces may be present, as has been illustrated in Fig. 1, as e.g. all of the refractory material parts outside the crucible container wherein the raw materials are present, such as any heat protecting shield or guiding plate or flap(6) avoiding undesired heating of said support, spatter of material escaping in an uncontrolled way as a consequence of e.g. "bumping", and/or any extra grid(s) and/or grating(s), present in the vapor cloud(s) or stream(s) escaping from the crucible(s) (throughout slits or openings in cover(s) or through a chimney) and present above the crucible, i.e. between crucible and support whereupon the photostimulable phosphor should be deposited in order to prepare a vapor deposited phosphor screen; all of the refractory material parts further optionally making part of that crucible unit construction inside the crucible container wherein the raw materials are present, such as any extra grid(s) and/or grating(s), wherein said extra grid(s) and/or grating(s) are present in the vapor cloud(s) or stream(s) escaping from the surface of the liquefied raw materials having been heated up to the temperature exceeding the melting temperature Tₘₑₗₜ, and/or any extra grid(s) and/or grating(s), wherein said extra grid(s) and/or grating(s) are present in the liquefied raw materials, together with extra surface enhancing refractory material that has been added to the crucible(s) in form of e.g. a powder, amorphous particles, spheres, bars, sticks, ingots and curls, according to the method of the present invention.

In the vapor depositing process according to the present invention, within said vapor deposition apparatus said crucible unit(s) are thus, besides said crucible(s), provided with one or more additional refractory parts in form of cover(s), grid(s), grating(s), flap(s), shield(s) or screen(s), and at least one of said refractory parts, having been used in a former vapor depositing process is, at least in part, provided with renewed and/or refreshed surfaces of fresh or refreshed refractory material.

According to the method of the present invention, a set of up to 25 storage phosphor plates is consecutively manufactured in that way wherein deviations in speed from one plate to another within said set are less than 10 %, provided that particles added to a crucible unit in said apparatus are in form of a powder.

Further according to the method of the present invention, said refractory material surfaces are metals selected from the group consisting of Ta, Ti, Mo and W or a combination thereof.

In one embodiment according to the method of the present invention, said powder is tantalum powder. Amounts of said tantalum powder to be added to the crucible(s) are in the range from 0.5 to 5% by weight, and more preferably in the range from 0.5 to 1.5% by weight versus the total weight of raw materials, i.e. of a matrix component and an activator component, or a phosphor precursor component or a combination thereof.

In another embodiment according to the method of the present invention, refractory material surfaces, present as extended refractory material surfaces besides said particles, comprise an optionally present extended chimney, cover(s), baffle plate(s), grid(s), grating(s), flap(s), shield(s) and/or heat-protecting screen(s); all additional refractory material parts within a crucible coming into contact with vaporized and/or liquefied raw materials and all additional parts present within a vapor deposition apparatus coming into contact with vaporized raw materials.

In still another embodiment according to the method of the present invention, said method comprises a step of providing a refractory surface as a fresh or refreshed refractory surface before starting said vapor deposition process. In order to provide a fresh, refreshed or refreshable reactive tantalum or molybdenum surface it is important to remove oxides, oxy halides and halide corrosion layers and, in addition, even metal layers - at least the deeper partly corroded metal layers -, before starting a new vaporization process. It is thus, according to the present invention, more particularly recommended to remove corroded layers such as metal oxide or metal halide layers and even metal layers at the start of a new vaporization process. In a particular embodiment thereof in the method according to the present invention a refreshed refractory surface is offered by removing corroded surface layers thereof, wherein removing said layers proceeds by at least one or a combination of techniques selected from the group consisting of physically removing, chemically removing, electrochemically polishing, reactive ion treating, glow discharge treating, sandblasting, shot cleaning and ultrasonically treating. Refractory crucible(s) provided with refreshed surfaces, are thus refreshed by one or a combination of techniques selected from the group consisting of physically removing (e.g. mechanically polishing), chemically removing(of the oxidation layer(s) e.g. by further oxidation and removing the layer addition of complexing agents), electrochemically polishing, reactive ion treating, glow discharge, sandblasting, shot cleaning and ultrasonically treating surface layer(s) thereof. Chemically removing the oxidation layer(s) present after a vapor deposition process at high temperatures is e.g. performed by further oxidation - e.g. in a strong acid as e.g. nitric acid - and removing the corroded layer(s) by addition of complexing agents - such as e.g. fluorides or chlorides, besides addition of oxidizing and/or reducing agents, an electrochemically polishing treatment (wherein oxidation and/or reduction cycles may be applied consecutively), a reactive ion (beam) treatment, a glow discharge treatment, a sand blasting treatment, a shot cleaning treatment with metallic parts, an ultrasonic treatment, or a combination of more than one of the mentioned techniques, without however being limitative. It is clear that in any case wherein an extra refractory material is present, the reactive surface thereof increases to a large extent. This is more particularly the case when in a crucible unit, besides a boat or crucible as an essential part to contain raw materials, all extended parts built up from a refractory material coming into contact with liquefied and/or vaporized raw materials have to be taken into account such as an optionally present extended chimney, two or more covers or cover plates (optionally perforated or provided with a slit in order to allow vapor to escape in order to become deposited onto a substrate or support, acting as a carrier for the deposited phosphor layer(s)), one or more baffle plate(s) (allowing to control starting evaporation conditions), all heat-controlling means (such as a protecting shield or guiding plate or flap avoiding undesired heating of said support, thereby avoiding spatter of material escaping in an uncontrolled way as a consequence of "bumping" acting as shielding or heat-protecting screen(s) and, e.g., thermocouples covered with a refractory material, flap(s), grid(s) and grating(s) - preferably provided with slit(s) and/or openings - as optional parts of said crucible(s) and all other additional refractory material parts present in the vapor depositing apparatus.

More particularly when present in a more finely divided form such an extra refractory material, according to the method of the present invention, contributes to the reactive surface to a more important, higher extent. So a vapor depositing process as taught hereinbefore, advantageously comprises as an additional step of said process, the step of adding refractory material in form of powder(s), crystalline particles, amorphous particles, spheres, bars, sticks, ingots or curls.

In the method according to the present invention raw materials to be vaporized are matrix component(s), activator component(s), precursor component(s) of matrix and/or activator component(s) or combinations thereof.

In the case where a phosphor layer is formed by multi-vapor deposition (co-deposition), at least two evaporation sources may be used. One of the sources may contain a matrix compound of the energy-storable phosphor, while the other may contain an activator compound. In another embodiment mixtures of matrix and activator compound may be added to one (in case of a single evaporation source) or more crucibles (in case of multivapor deposition). In the last case the vaporization rate of each source may be independently controlled in order to incorporate the activator uniformly in the matrix, more particularly if the compound, separated or in form of mixtures thereof has very different melting points or vapor pressures. According to the composition of the desired phosphor, each evaporation source may contain the matrix compound or the activator compound only or otherwise, as most preferred within the scope of the present invention, in form of a mixture thereof. Three or more sources may even be used. So in addition to the above-mentioned sources, an evaporation source containing additives may be used.

The matrix compound of the phosphor may be either the matrix compound itself or a mixture of two or more substances that react with each other to produce the matrix compound. The activator compound generally is a compound containing an activator element, i.e., a halide or oxide of the activator element.

With respect to the preferred starting materials to be vaporized from the crucible, in one embodiment use is made of a mixture of "raw materials" defined above as starting products or starting components.

In one embodiment according to the method according to the present invention, said matrix component is represented by the formula (I)

M¹X.aM²X'₂.bM³X"₃ (I)

wherein
M¹ represents an alkali metal selected from the group consisting of Li, Na, K, Rb and Cs;
M² represents a divalent metal selected from the group consisting of
Be, Mg, Ca, Sr, Ba, Zn, Cd, Cu and Ni;
M³ represents a trivalent metal selected from the group consisting of Sc, Y, La, Ce, Pr, Nd, Pm, Sm, Eu, Gd, Tb, Dy, Ho, Er, Tm, Yb, Lu, A1, Ga and In; X, X' and X" each represent a halogen selected from the group consisting of F, Cl, Br and I; a and b each represent 0 ≤ a < 0.5 and 0 ≤ b < 0.5.

In the vapor depositing processes as set forth said raw materials preferably are alkali halide salt matrix component(s). So according to a particular embodiment in the method of the present invention, said matrix component is CsX, wherein X represents Cl, Br, I or a combination thereof. Further according to that embodiment in the method of the present invention, said activator component is a component having as activator element represented by symbol A, an element selected from the group consisting of Eu, Tb, Bi, In, Ga, Cs, Ce, Tm, Dy, Pr, Ho, Nd, Yb, Er, Gd, Lu, Sm, Y, Tl, Na, Ag, Cu and Mg.

More specifically in the method according to the present invention, said activator component is a halide salt, an oxide, a halide and/or oxyhalide of said activator element, and still more specifically said activator component is one of EuX₂, EuX₃, EuOX, wherein X represents Cl, Br, I or a combination thereof.

In another embodiment in the method according to the present invention, said precursor component is CsₓEu_{y}X'_{(x+αy)}, wherein x, y and a are integers, wherein x/y is 0.25 or more, wherein α is at least 2 and wherein X' represents Cl, Br, I or a combination thereof. More particularly said precursor component is selected from the group consisting of CsEu₄Br₉, CsEu₂Br₅, CsEuBr₃, Cs₂EuBr₄ and Cs₃EuBr₅.

With respect to the preferred starting materials to be vaporized from the crucible, in one embodiment use is made of a mixture of "raw materials" defined above as starting products or starting components. More in particular as in the proceeds according to the present invention, wherein a CsX:Eu phosphor is envisaged to be prepared, CsX as a pure alkali halide salt is advantageously used as main or matrix component, whereas as pure activator salt use is preferably made of EuX₂, EuX₃, EuOX, Eu₂O₃ or a combination thereof, X representing a halide being Cl, Br, I or a combination thereof. According to the method of the present invention said storage phosphor in said storage phosphor plate is thus a CsBr:Eu photostimulable phosphor.

Matrix component and activator compound, whether mixed or not, may be added to one or more crucibles and vaporized from the said one or more crucibles. A suitable raw material as europium dopant precursor for the preparation of CsBr:Eu screens is EuOBr, wherein europium is trivalent. After vapor deposition however, europium is present in the phosphor as divalent europium in substantially excessive amounts (more than two, and more preferably even more than three orders of magnitude) versus trivalent europium. Preparation methods of the desired CsBr:Eu phosphors may thus be performed, starting from CsBr and EuOBr as has been described in PCT-Application WO 01/03156, filed June 19, 2000, wherefrom as a preferred method for manufacturing a binderless phosphor screen, a method has been selected as bringing heatable multiple containers of CsBr and an Europium compound selected from the group consisting of EuX'2 EuX'3 and EuOX', X' being selected from the group consisting of C1 (if required in desired co-doping amounts) and Br together with the substrate in a deposition chamber evacuated to at least less than 10⁻¹ mbar; and depositing, by a method selected from the group consisting of physical vapor deposition, chemical vapor deposition or atomization techniques, both said CsBr and said Europium compound on a substrate in such a ratio that on said substrate a CsBr phosphor, doped with Europium is present. When use is made of a precursor salt as CsₓEu_{y}X'_{(x+αy)}, mentioned hereinbefore, such precursor salt or salts are vaporized from one crucible only or from more than one crucible, whether or not in a mixture together with CsX as main component. For the selected photostimulable CsBr:Eu storage phosphor plates, prepared by the method of the present invention, it is clear that each of X and X' where mentioned, advantageously represents Br.

An essential aspect of the present invention as already been set forth hereinbefore is related with the step of providing a "refractory" surface as a fresh or refreshed refractory surface at the start of a vapor deposition process, wherein the same "refractory surface", although in part corroded after ending that vapor deposition process should be "refreshable" in order to provide a "refreshed" surface for the next vapor deposition process. A "new", "fresh", "renewed" or "refreshed" reactive total surface present as an additional cover, grid, flap or screen material means that is of particular importance to remove oxides, oxy halides and halide corrosion layers and, in addition, even metal layers - at least the partly corroded metal layers in the vicinity of or adjacent to the corroded -, before starting a new vaporization process. Although having been defined hereinbefore as expressing "capability of enduring or resisting high temperature" as in the context of the present invention, it is clear that such refractory surface layer(s) is(are) not quite inert with respect to resisting severe chemicals (as oxygen and halogens) at those high temperatures.

As in the present invention consecutive processes are envisaged in order to reproducibly prepare a series of phosphor plates or panels, a former vapor depositing process is at least the second in a number of a series of consecutive vapor depositing processes. More preferably in the vapor depositing process according to the present invention said former vapor depositing process is at least the fifth in a number of a series of consecutive vapor depositing processes, more preferably at least the tenth, and even most preferably at least the twentieth. The more reproducible storage phosphor plates are consecutively prepared in this way, the lower the cost and the more cost efficient the processes are performed.

The same refractory surface, although at least in part being corroded after ending each vapor deposition process in the same vapor depositing apparatus under reduced pressure, should - at least in part - be refreshable or renewable, wherein corroded parts should be removed and replaced by new parts, in part or integrally, but preferably treated as explained in detail above, in order to be recovered and reused after a "refreshing" treatment, and thus in order to provide a refractory surface as a fresh or refreshed refractory surface at every new start of a vapor deposition process.

Consecutively thus prepared photostimulable phosphor screens or panels contain at least one of Ta, W, Ti and Mo or a combination thereof in an amount of from 1 p.p.m. to 100 p.p.m. (µmol/mol) versus CsBr in the desired CsBr:Eu phosphor.

According to the method of the present invention, said phosphor plate is non-colored and tantalum is present in an amount of from 1 to 50 p.p.m..

With respect to impurities, other than a dopant as mentioned hereinbefore, the evaporation source, particularly the source containing the matrix compound, may contain impurities of alkali metal (alkali metals other than ones constituting the phosphor) in a content of 100 p.p.m. or less. As in the vapor deposition process it is important to prevent the raw material sources in the crucible(s) from bumping, it is particularly important to control the water content in the above low range if the compound of matrix or activator is a hygroscopic substance such as europium or cesium bromide.

In the vapor deposition process two or more evaporation sources besides the substrate or support may be placed in a vacuum evaporation-deposition apparatus. The apparatus is then evacuated to give a medium vacuum of 0.05 to 10 Pa, preferably 0.2 to 4 Pa. It is particularly preferred that, after the apparatus has been evacuated to a high vacuum of 1 x 10⁻⁴ to 1 x 10² Pa, an inert gas such as Ar, Ne or N₂ gas is introduced into the apparatus so that the inner pressure can be the above-mentioned medium vacuum. In this case, partial pressures of water vapor and oxygen can be reduced. The apparatus can be evacuated by means of an optional combination of, for example, a rotary pump, a turbo molecular pump, a cryo pump, a diffusion pump and a mechanical booster.

For heating the evaporation sources, electric currents are then supplied to resistance heaters. The sources of matrix and activator compounds are thus heated, molten, reacted with a fresh or refreshable refractory surface (such as e.g. a tantalum surface), vaporized, and reacted with each other to form the phosphor, which becomes deposited and accumulated onto the support. The space between the substrate and each source varies depending upon various conditions such as the size of the substrate. Generally that size is in the range of 1 to 100 cm, preferably in the range of 1 to 20 cm. The space between adjoining sources generally is in the range of 1 to 100 cm. In this step, the substrate or support can be heated or cooled. The temperature of that substrate is generally kept in the range from 100 to 300°C, and more preferably in the range from 135 to 235°C. Variations of the temperature of the substrate occurring during the deposition process preferably are not more than 50°C, more preferably not more than 30°C, and even most preferably not more than 20°C. The deposition rate, expressing how fast the formed phosphor is deposited and accumulated onto the substrate, may be controlled by adjusting the electric currents supplied to the heaters. The deposition rate generally is in the range of 0.1 to 1,000 µm/min, preferably in the range of 1 to 100 µm/min.

Before starting the deposition of the phosphor layer, an undercoat layer mainly comprising the matrix compound may be formed on the support as an intermediate layer between support and vapor deposited phosphor layer. Both layers may also be vapor deposited successively on the support. This can be performed by first heating and evaporating an evaporation source of a matrix compound only, in order to deposit the matrix compound on the support, followed by heating and evaporating the evaporation source(s) of matrix compound, activator compound, precursor compound(s) or mixtures thereof in order to deposit the desired phosphor onto the first deposited (matrix) layer. The support may also be heated when the depositions are carried out. The support is preferably kept at a temperature of 135 to 235°C. A variation of that substrate temperature during said deposition process is preferably not more than 50°C as has been disclosed in EP-A 1 426 977.

After the deposition procedure is complete, the deposited layer is preferably subjected to heat treatment (annealing), which is carried out generally at a temperature of 100 to 300°C for 0.5 to 4 hours, preferably at a temperature of 150 to 250°C for 0.5 to 4 hours, under inert gas atmosphere which may contain a small amount of oxygen gas and/or water vapor.

It is well known that needle-shaped crystals thus prepared act, to a certain extent, as light guides, thereby reducing lateral spread of stimulation and emission light in the phosphor layer. The dimensions of those crystals are preferably in the range of as 2+ disclosed in EP-A 1 359 204: needle-shaped CsBr:Eu storage phosphor crystal particles in form of a cylinder suitable for use in flat storage phosphor panels have been provided, said particles having an average cross-section in the range from 1 µm up to 30 µm and an average length, measured along the casing of said cylinder, in the range from 100 µm up to 1000 µm. Such a cylindrical shape of parallel aligned phosphor needles in a photostimulable phosphor layer should avoid transversal diffusion of stimulating excitation light and should render the photostimulable phosphor layer columnar, so that the light reaches the support surface while repeating reflection in a crack or columnar crystal interface, thereby noticeably increasing the sharpness of images formed by stimulated emission radiation.

Formed deposited layers composed of an underlayer comprising a matrix compound of the phosphor and, thereupon and in contact therewith, the phosphor layer comprising an energy-storable phosphor in form of a columnar structure almost grown in a thickness direction, generally have a thickness of 50 µm to 1 mm, and more preferably 200 µm to 700 µm.

It should be mentioned that the vapor deposition technique as gas phase-accumulation method applied in the present invention is not restricted to the above-described resistance heating procedure. Various other processes known in the art, such as a sputtering process, an electron beam process and a CVD process may also be used.

It is preferred to provide a protective layer onto the surface of the phosphor layer in order to ensure good handling or manutention of the storage phosphor panel while transporting it and thus to avoid damaging. The protective layer is preferably transparent. Depending on the scanning technique prevention of stimulating light to enter and to allow emitted stimulated light to come out, the protective layer may be coloured. More generally the storage phosphor panels are advantageously provided with colored, nanocrystalline dyes in the phosphor layer, e.g. as disclosed in EP-A 1 349 177, although colored supports, absorbing at least 30% of the stimulating light and reflecting at least 60% of the stimulated emission light as in EP-A 1 316 971 are advantageously applied too, in favour of sharpness.

Protection of the storage phosphor panel from chemical deterioration and physical damage should be provided by making the protective layer chemically stable, physically strong and high moisture proof. Once deposited in a layer, the CsBr:Eu type phosphors, which are indeed very sensitive to moisture, are advantageously protected against said moisture by applying a layer of the preferred parylene type polymers as disclosed in relation with CsBr:Eu type phosphor panels e.g. in US-P 6,710,356 and in EP-A's 1 286 362, 1 286 363 and 1 286 365. A protective organic film vapor deposition method for parylene films may be applied as described in US-A 2001/030291. Other preferred protections, e.g. for the protective layer applied onto the phosphor layer and providing protection against scratches as described in EP-A's 1 453 065 and 1 453 066, and in EP-A 1 541 333.

A phosphor plate or panel, comprising a phosphor layer on a support, wherein said phosphor layer is prepared by a vapor depositing process according to the present invention is thus particularly preferred.

Such a photostimulable phosphor panel may be provided with a reflecting support. As such a reflecting support reflects stimulation radiation and stimulated radiation, it is clear that an enhanced speed is obtained in this particular application wherein speed is highly desired. Choice of a dedicated reflecting layer onto said support in order to reduce scattering to a minimum level in favour of image definition is recommended. In the present invention therefore a substrate characterised by a surface roughness of less than 2 µm and a reflectivity of more than 80%, more preferably more than 90% and even more than 95% as set forth in US-A 7,026,632is particularly recommended. A highly reflecting metal layer (more particularly, a highly reflecting aluminum or silver layer) on e.g. an aluminum support or an amorphous carbon layer support (as disclosed in US-A 2004/262535, without however being limitative as an example of a supporting layer), are particularly suitable in mammographic applications. As a thin reflective mirror layer a metallic layer is preferably used, like e.g. silver mirror or, more preferably, an aluminum layer (having a thickness of about 1 µm), deposited onto an about 2 mm thick support layer (e.g. amorphous carbon - a-C layer -, another aluminum sheet or a polymeric support layer). Most commonly used is an aluminum layer, deposited by means of the vapor deposition technique, having as an additional advantage that it exhibits thermal conductivity. As taught in US-A 2004/081750, in one embodiment thereof, the phosphor is deposited by physical vapor deposition on said substrate characterised in that during deposition said substrate is at a temperature in the range of 135°C to 235°C, wherein a variation of the temperature of the substrate occurring during said deposition process is not more than 50°C. At lower temperatures as e.g. in the range from 50°C to 150°C the said thermal conductivity may become even more important as for the support temperature there is a tendency that the thickness of the phosphor layer is decreased when the temperature is more lowered during vapor deposition of the phosphor layer, providing an increased number of needle-shaped crystals per square unit.

Polymeric support films known in the art may be used as main support layer as, e.g., polyester film, polyvinylchloride, polycarbonate, and syntactic polystyrene, without however being limited thereto. Preferred polymeric films are polyester ester film, such as e.g., polyethyleneterephthalate films, polyethylenenaphthalate films. Polyimide is another example of a suitable support material. Besides the support auxiliary layers may be present, the thickness of which in principle ranges from 1 µm to 500 µm. It may be advantageous to have a support including a composite material of a matrix resin and a carbon fiber, and a heat resistant resin film provided on a face of the substrate. As a glass-transition temperature of the matrix resin a temperature of not less than 100°C and not more than 300°C may be preferable. Such a support may thus comprise a plurality of layers of two or more kinds. As an example thereof, without however being limited thereto the support may e.g. comprise a carbon reinforced layer package, having, in order, a first polyimide layer, a carbon fiber layer and a second polyimide layer. A plurality of carbon fiber reinforced resin sheets, each of which including carbon fibers arranged in a direction and impregnated with a heat resistant resin, may be present and directions of the carbon fibers in the carbon fiber reinforced resin sheets may be the same, but may differ from each other and may be arranged at approximately equal angles. Instead of the cited polymeric film supports, it is however possible to make use of a fairly thin amorphous carbon film, e.g., 400 µm. A laminate of a 500 µm thick auxiliary film may be applied to it at the side away from the phosphor layer. It is also possible to use a thick amorphous carbon film, e.g., 2000 µm thick with a thin, e.g., 6 µm thick, polymeric film laminated onto it. The relative thickness of amorphous carbon and polymeric film may be varied widely and is only directed by the required physical strength of the amorphous carbon during deposition of the phosphor layer and the required flexibility of the panel during use. Alternatively the support may even comprise at least one selected from the group consisting of chemically reinforced glass and crystallized glass.

More particular coating or manufacturing methods within a sealed zone maintained under vacuum conditions, by the step of vapor deposition, wherein said phosphor layer is, continuously or discontinuously, deposited onto a substrate, and wherein said substrate is deformed at least before, during or after said step of vapor deposition, in order to provide the manufacturer, by a process of exceptionnally high yield, with large deposited phosphor sheets having constant speed and image quality properties, further offering availablity of all formats as desired for screens, plates or panels ready-for-use in a scanning apparatus in computed radiography, may be performed as has been disclosed in US-A 2004/224084.

In a method for homogeneously and dust-free coating of a phosphor layer onto a flexible substrate, in order to obtain a plurality of phosphor sheets or panels having flexible supports or substrates, a coating procedure within a sealed zone may be performed, wherein said zone comprises at least two cylindrical carrier rollers for carrying a flexible substrate exceeding dimensional formats of desired phosphor sheets or panels with a factor of at least 5, wherein said cylindrical carrier rollers each have an axis in a parallel arrangement with one another; wherein said zone comprises at least one crucible containing a mixture of raw materials providing desired phosphor compositions for said layer; and wherein said zone comprises a laminating unit; wherein said method comprises the steps of mounting said flexible substrate onto said carrier rollers, vapor depositing said phosphor layer having a desired phosphor composition onto said flexible substrate, and laminating said phosphor layer, thereby covering said layer with a protective foil; and further comprises the step of cutting said layer into sheets or panels having desired formats, and at least during said vapor depositing step said zone is maintained under vacuum conditions as a vacuum chamber, as has been filed in US-Application 2004/224084.
Improvements in crucible configurations for evaporating raw materials as set forth may successfully be applied by making use of an assembly as described in EP-A's 1 496 133 and 1 496 134.

In a photostimulable phosphor panel according to the present invention, cations selected from the group consisting of Li, Na, K, Tl, Ca, Ba, Pb, Ni, Cr, Cu, Fe and Bi are (optionally) present in addition to the vapor deposited stimulable phosphor, provided with the activator dopant and "co-dopants" in amounts therein as set forth hereinbefore. Na, K, Ca and Pb are most frequently effectively analytically detected therein in excess to their "natural impurity level" after addition in minor amounts thereof, i.e. in amounts in the range up to less than 10 p.p.m..

### EXAMPLES

While the present invention will hereinafter, in the examples, be described in connection with preferred embodiments thereof, it will be understood that it is not intended to limit the invention to those embodiments.

### Example 1

CsBr:Eu screens were made via thermal vapor deposition of CsBr and EuOBr. Therefor 597 g of CsBr was mixed with 3 g of EuOBr (0.5 % by weight versus the main component) and the mixture was placed in a crucible (dimensions: 15 cm x 6 cm x 3.5 cm) in a vacuum deposition chamber. The phosphor was deposited on an aluminum layer support having an anodised surface layer thereupon, said substrate having as dimensions 247 mm x 185 mm x 280 µm.
The distance between the container and the substrate was 195 mm. During evaporation, the substrate was rotated at 12 r.p.m.. The container with starting materials was heated to a temperature of 725 + 5°C. Before the start of the evaporation, the chamber was evacuated to a pressure of 4 mPa. During the evaporation process, Ar was introduced in the chamber at a pressure between 1.0 and 2.5 Pa, whereas the substrate was heated up to a controlled temperature of 200°C.
Refractory materials, more in particular, metals as tantalum and molybdenum in form of powders and plates or screens were delivered by H.C. Starck, Liaison Office Benelux, Mijdrecht, The Netherlands.

In a first (comparative) array of experiments (CB52111 & CB52712-52714), representing the state-of-the-art, use was made of a crucible wherein no extra added tantalum or molybdenum as a refractory material was present (as powder, curls, spheres, bars, grids, etc...) besides its presence as a "standard crucible material", as one intermediate cover material, whether or not reinforced (as in CB52712-52714), installed in order to avoid sputtering of starting material upon the support or substrate material whereupon the storage phosphor should be vapor deposited.

In a second (inventive) array of experiments (CB52702) an extra amount of tantalum curls was added. As a consequence thereof an increased amount of fresh tantalum surface was providing an extra or extended refractory material surface (ERMS) and an increased reactive crucible ratio (RCR).

In a third (inventive) array of experiments extra amounts of tantalum powder were added.

In a fourth (inventive) array of experiments a tantalum grid was installed besides an intermediate crucible cover.

In a fifth (inventive) array of experiments a Mo screen, as a refractory screen made in another material, was installed in order to prevent temperature increase of the environment, more particularly from the support whereupon the vapor should be deposited.

In the Table 1 hereinafter an overview of the varying experiments as described above is given. Therein the ERMS surface of the crucible unit (i.e. all extended parts defined hereinbefore and made in refractory material) which partly makes contact with the raw materials in liquid form, and/or partly with the vaporized materials has been calculated. Part of the inner surface of the crucible contacting the raw materials before starting said vaporization, i.e., in the liquid (molten) state is calculated too, taking into account the inner surface on the bottom of the crucible and the inner surface of the walls, covered with liquid - molten - raw materials, for a crucible having as dimensions 15 cm x 6 cm x 3.5 cm, 3.5 cm representing its height and wherein only 1.5 cm thereof is covered with liquid material. For CsBr, as in these experiments, a temperature exceeding the melting temperature of 640°C is required in order to get the raw materials in the molten or liquid state.

Parameters making the fresh, refreshed or refreshable tantalum or molybdenum surface (defined as ERMS = Extended Refractory Material Surface, expressed in cm²) variable were
(1) the variation of an additional grid as a consequence of variations of the construction of the crucible and
(2) variation in amounts of parts of refractory materials such as tantalum powder or curls added to the molten raw materials contacting the phosphor precursors.
   Variations of ERMS values, thus performed, automatically provoke changes in "Reactive Crucible Ratios" (RCR-values).
   All square units are given in cm² as has already been mentioned.
   Europium amounts (µmole/mole) are further given, as well as the phosphor coverage of vapor deposited phosphor onto the photostimulable phosphor plate (mg/cm²) and relative speed (as SAL%): the speed of each of the screens was compared therefore with the reference speed of an MD10^{®} reference photostimulable phosphor screen manufactured by Agfa-Gevaert, Mortsel, Belgium.

In the Table 1 the IRMS surface of the crucible unit (i.e. all internal part defined hereinbefore, present in refractory material contacting liquefied raw material defined hereinbefore, as well as part of the inner surface of the crucible contacting the raw materials just before starting said vaporization, i.e. in the liquid (molten) state, has also been given. For CsBr, as in this case, a temperature exceeding the melting temperature of 640°C is required in order to get the raw materials in the molten or liquid state. Part of the crucible surface contacting liquid or molten raw materials was always 153 cm² (taking into account the inner surface on the bottom of the crucible and the inner surface of the walls, covered with liquid - molten - raw materials, for a crucible having as dimensions 15 cm x 6 cm x 3.5 cm, 3.5 cm representing its height and wherein only 1.5 cm thereof is covered with liquid material).

The fresh internal refractory material or molybdenum surface (defined as IRMS = Internal Refractory Material Surface, expressed in cm²) as more particularly envisaged in the present invention was the tantalum added to the molten or liquefied raw materials in variable amounts in form of tantalum powder or curls.

Variations of IRMS values, thus performed, automatically provoke changes in "Internal Reactive Crucible Ratios" (IRCR).

**Table 1**

| CB | ERMS | RCR | IRMS | IRCR | Amt (g) | Eu amt. | Phosp. cov. | SAL% |
|---|---|---|---|---|---|---|---|---|
| No add. | (comp.) | | | | | | | |
| 52111 | 0 | 0 | 0 | 0 | 0 | 189 | 189.4 | 372 |
| 52712 | 0 | 0 | 0 | 0 | 0 | 257 | 196.2 | 333 |
| 52713 | 0 | 0 | 0 | 0 | 0 | 212 | 188.2 | 319 |
| 52714 | 0 | 0 | 0 | 0 | 0 | 228 | 179.4 | 344 |

| Ta curls | (inv.) | | | | | | | |
|---|---|---|---|---|---|---|---|---|
| 52702 | 48 | 0.314 | 48 | 0.314 | 5 | 148 | 193.25 | 583 |

| Ta powder | (inv.) | | | | | | | |
|---|---|---|---|---|---|---|---|---|
| 52731 | 408.3 | 2.67 | 408 | 2.67 | 5 | | 191.3 | 647 |
| 52732 | 408.3 | 2.67 | 408 | 2.67 | 5 | | 194.3 | 749 |
| 52733 | 408.3 | 2.67 | 408 | 2.67 | 5 | | | 692 |
| 52734 | 408.3 | 2.67 | 408 | 2.67 | 5 | | 192.6 | 664 |
| 52735 | 408 | 2.67 | 408 | 2.67 | 5 | | 195.3 | 768 |
| 52726 | 572 | 3.74 | 572 | 3.74 | 7 | | 193.1 | 565 |
| 52721 | 163 | 1.07 | 163 | 1.07 | 2 | | 191.0 | 704 |
| 52722 | 408 | 2.67 | 408 | 2.67 | 5 | | 190.4 | 723 |
| 52723 | 572 | 3.74 | 572 | 3.74 | 7 | | 188.6 | 658 |
| 52724 | 817 | 5.34 | 817 | 5.34 | 10 | | 175.8 | 619 |
| 52711 | 163 | 1.07 | 163 | 1.07 | 29 | 175 | 196.0 | 688 |
| 52709 | 408 | 2.67 | 408 | 2.67 | 59 | 169 | 193.0 | 643 |
| 52649 | 408 | 2.67 | 408 | 2.67 | 59 | | 183.0 | 621 |

| Ta grid | (inv.) | | | | | | | |
|---|---|---|---|---|---|---|---|---|
| 52339 | 427.5 | 2.79 | | | 0 | 149 | 214.4 | 673 |
| 52340 | 427.5 | 2.79 | | | 0 | 146 | 170.7 | 563 |

| Mo screen | (inv.) | | | | | | | |
|---|---|---|---|---|---|---|---|---|
| 51607 | 368 | 2.41 | | | 0 | 249 | 201.1 | 658 |
| 51608 | 368 | 2.41 | | | 0 | 265 | 200.2 | 696 |
| 51615 | 368 | 2.41 | | | 0 | 134 | 183.6 | 646 |
| 51617 | 368 | 2.41 | | | 0 | 157 | 192.9 | 616 |
| 51637 | 368 | 2.41 | | | 0 | 188 | 198.2 | 640 |

For all arrays of experiments represented in the Table 1, an average SAL% value <SAL%> was calculated as well as the standard deviation thereof σ<SAL%>.
Results have been summarised in Table 2.

**Table 2**

| Extra additions | CB Nos. | <SAL%> | σ_{<SAL%>} | RCR | %SAL dev. |
|---|---|---|---|---|---|
| No (Comp.) | 52111 & 52712-52714 | 402 | 84 | 0 | 20.9 |
| Ta curls(Inv.) | 52702 | 583 | - | 0.3 | - |
| Ta powder(Inv.) | 52731-52649 | 688 | 54 | > 1 | 7.8 |
| Ta grid(Inv.) | 52339-52340 | 618 | 77 | 2.8 | 12.5 |
| Mo screen(Inv.) | 51607-51637 | 651 | 29 | 2.4 | 4.5 |

As can be concluded from the Table 2, summarizing the results of the different, comparative arrangements without extra additions as made in the experiments CB52111 & 51712-CB52714 are not improved in speed and its standard deviation upon the average value is rather high.

Addition of curls makes speed increase, even for a low RCR value (about standard deviations of speed values nothing can be concluded as there was only made one experiment).

Addition of an extra grid or a screen further makes speed to increase while RCR values are exceeding a value of 1, with a decrease of standard deviations thereupon.

Addition of tantalum powder provides a remarkable increase in speed, and is moreover in favor of reproducibility of said speed increase for the photostimulable phosphor screens thus prepared.

### Example 2

CsBr:Eu screens were made via thermal vapor deposition of CsBr and EuOBr. Therefor 597 g of CsBr was mixed with 3 g of EuOBr (0.5 % by weight versus the main component) and the mixture was placed in a crucible (dimensions: 15 cm x 6 cm x 3.5 cm) in a vacuum deposition chamber.

The phosphor was deposited on an aluminum layer support having an anodised surface layer thereupon, said substrate having as dimensions 247 mm x 185 mm x 280 µm.

The distance between the container and the substrate was 195 mm. During evaporation, the substrate was rotated at 12 r.p.m..

The container with starting materials was heated to a temperature of 725 ± 5°C.

Before the start of the evaporation, the chamber was evacuated to a pressure of 4 mPa. During the evaporation process, Ar was introduced in the chamber at a pressure between 1.0 and 2.5 Pa, whereas the substrate was heated up to a temperature of 220°C.

Refractory materials, more in particular, metals as tantalum and molybdenum in form of powders and plates or screens, were delivered by H.C. Starck, Liaison Office Benelux, Mijdrecht, The Netherlands.

In Table 3 hereinafter a set of experimental results has been given wherein use has been made of different refractory crucibles (made in tantalum metal - see TK numbers).

The numbers of consecutive runs the crucibles have been used in the same vapor deposition apparatus before the experimental results obtained therewith have been given in the Table 3, as well as
- coated amount of phosphor (expressed in mg/cm²);
- amount of tantalum powder added to the crucible before starting the vapor deposition processes (expressed in g - exceptionally in the last experiment wherein 5 g of curls - see CURLS - instead of powder was added);
- %SAL expressing the speed or sensitivity of each of the screens, compared therefore with the reference speed of an MD10^{®} reference photostimulable phosphor screen manufactured by Agfa-Gevaert, Mortsel, Belgium; and
- MTF, expressing - in % - the modulation transfer function at 1 line pair per mm and representing image sharpness (the higher the better, i.e. the sharper the images).

**Table 3**

| Exp. No. | Amt. of Ta powder (g) | Amt. of coated phosphor(mg/cm²) | Crucible No. | Number of runs | %SAL | MTF 1 lp/mm (%) |
|---|---|---|---|---|---|---|
| CB52504 | 0 | 168 | TK310406 | 25 | 253 | 97 |
| CB52505 | 0 | 163 | TK310407 | 1 | 317 | 97 |
| CB52627 | 0 | 206 | TK310410 | 1 | 515 | 109 |
| CB52731 | 5 | 191 | TK310412 | 1 | 647 | 96.2 |
| CB52805 | 2 | 193 | TK310412 | 19 | 596 | 98 |
| CB52806 | 2 | 204 | TK310417 | 1 | 668 | 103 |
| CB52830 | 2 | 175 | TK310417 | 23 | 563 | 94.5 |
| CB52917 | 2 | 176 | TK310419 | 1 | 650 | 106 |
| CB52918 | 2 | 166 | TK310419 | 2 | 639 | 100 |
| CB52702 | 5 (CURLS) | 181 | TK310410 | 25 | 376 | 109 |

Starting vapor depositing with an apparatus provided with fresh tantalum crucibles and other addenda made in refractory material provide an average comparative speed of less than 630. Although amounts of phosphor deposited in the process should be taken into account, it is clear that after a series of runs, the process tends to lead to losses in speed. It is clear from the description and from the examples as set forth in the present invention that the refreshing procedure of the refractory surface of the crucible, acting as a container for the raw materials is decisive for the results obtained with respect to the reactive crucible surface. It is clearly recommended to add more finely divided tantalum powder (acting better than curls, coarser than powder material) to the raw materials in the refreshed crucibles after frequent reuse and refreshment, in order to, at least in part, restore probable losses in speed while consecutively producing screens or panels in a series production thereof.

### Example 3

Refractory materials, more in particular, metals as tantalum and molybdenum in form of powders and plates or screens, were delivered by H.C. Starck, Liaison Office Benelux, Mijdrecht, The Netherlands.

### Inventive example 3.1

CsBr:Eu screens were made via thermal vapor deposition of CsBr and EuOBr. Therefor 597 g of CsBr was mixed with 3 g of EuOBr (0.5 % by weight versus the main component) and the mixture was placed in a crucible (dimensions: 15 cm x 6 cm x 3.5 cm) in a vacuum deposition chamber. The phosphor was deposited on an aluminum layer support having an anodised surface layer thereupon, said substrate having as dimensions 247 mm x 185 mm x 280 µm. The distance between the container and the substrate was 195 mm. During evaporation, the substrate was rotated at 12 r.p.m..
The container with starting materials was heated to a temperature of 725 ± 5°C. Before the start of the evaporation, the chamber was evacuated to a pressure of 4 mPa. During the evaporation process, Ar was introduced in the chamber at a pressure between 1.0 and 2.5 Pa, whereas the substrate was heated up to a controlled temperature of 200°C.

In this experiment, according to configuration "C590", it has been established that with a configuration as represented in Fig. 5, tantalum surfaces contacting liquefied raw material before starting vapor deposition were measured to be 153 cm². Otherwise the sum of all of the tantalum crucible surfaces contacting vapor clouds of vaporized raw materials while vapor depositing were measured to be 2 1555 cm .

The refractory crucible surface ratio RCSR, defined as a ratio of both values hereinbefore, thus is 0.098.

### Inventive example 3.2

A CsBr:Eu photostimulable phosphor screen on flexible anodized aluminum was prepared in a vacuum chamber via thermal vapor deposition on a flexible anodized aluminum support, moving in such a way that the momentary magnitude of the velocity was constant over its whole area, starting from a mixture of CsBr and EuOBr as raw materials. Referring to Fig. 1 in US-A 2004/224084 the cylindrical vacuum chamber (1) with a diameter of 1.4 m and a length of 1.75 m was containing an electrically heated oven (2) and a refractory tray or boat (3) (dimensions of the elongated boat composed of "stainless steel 1.4828" being now 1.00 m (length) x 4.0 cm (width) x 8.0 cm (depth), having a wall thickness of 3 mm), in which 4 kg of a mixture (4) of CsBr and EuOBr in a 99.5%/0.5% CsBr/EuOBr percentage ratio by weight were present as raw materials to become vaporized. The boat was covered with a metallic raster (14) having a mesh of 300 µm in order to reduce the formation of pits during evaporation. Under vacuum pressure (a pressure of 2x10⁻¹ Pa) maintained by a continuous inlet of argon gas into the vacuum chamber, and at a sufficiently high temperature of the vapor source (760°C) the obtained vapor was directed towards a moving sheet support (5) and was deposited thereon successively while said support was moving along the vapor stream (16). The anodized aluminum support (5) having a thickness of 380 µm, a width of 1.18 m and a length of 1.26 m, was mounted, with the anodized side at the side whereupon the phosphor should be deposited, around a cooled cylindrical support roller (6) having a diameter of 40 cm and a length of 1.18 m rotating in a controlled way by means of a motor around its axis. The anodized aluminum was moving with a constant linear velocity of 2 m per minute. The cooled cylindrical support roller (6) was thermally isolated from the support sheet (5) by means of a thermal isolation layer (7) and by means of a heat-resistant coiled springs (8), mounted circumferentially around the cylinder. The coiled springs (8) also interconnect both ends of the anodized aluminum plate in order to stretch the anodized aluminum around the support roller (6) and in order to overcome a loss of tension during heating up of the anodized aluminum, due to thermal expansion. The support (5) was actually resting on these coiled springs. The support (5) was heated up to 150°C by means of an infrared heater (9) and a reflector cage (10). The temperature was measured with a pyrometer (11). A pair of baffles (12) and (13) limits the vapor deposition area on the support (5) to a small region or sector of 28 cm of the support roller. In that way undesired deposition of phosphor (as e.g. on the wall of the chamber) was prevented. Another pair of separation plates (15) was dividing the vacuum chamber (1) in an evaporation chamber part (18) and a heating chamber part (19). A CsBr:Eu stimulable phosphor layer having a mean thickness of 725 µm was deposited over the entire length of the support in successive steps, during which the thickness of the deposited layer was increasing, within a time of 79 minutes. The support was successively passing the vapor stream over the refractory boat or tray 125 times. The layer was thereby growing with an increasing thickness of 5.8 µm per rotation. During each rotation the layer was only growing effectively during a time of 0.14 minutes (= 0.28 m per 2 m per minute). This corresponds with a time of 8.4 seconds while the support was passing the deposition window of 0.28 m. During the condensation process, the effective deposition speed, expressed as layer thickness per time unit, was 41 µm per minute or 0.7 µm per second. A thickness homogeneity between 675 µm and 775 µm was obtained over a distance of 73 cm in a direction perpendicular to the moving direction and over a length of 1.20 m in the moving direction. 75 % by weight of the evaporated material was deposited onto the support. The area of the above described imaging plate, effectively suitable for practical use was 0.87 m².
In this experiment, according to configuration "M15", it has been established that with a configuration as represented in Fig. 1 of the said US-A 2004/224084, tantalum surfaces contacting liquefied raw material before starting vapor deposition were measured to be 1,042.72 cm². Otherwise the sum of all of the tantalum crucible surfaces contacting vapor clouds of vaporized raw materials while vapor depositing were measured to be 6,421.70 cm².

The refractory crucible surface ratio RCSR, defined as a ratio of both values hereinbefore, thus is 0.162.
For both inventive examples 1 and 2, although being illustrative for a strongly different configuration, it has been found that storage phosphor panels were prepared having an excellent screen speed with a good image quality and that reproducible results were obtained for identically repeated experiments.

### Comparative examples

In a comparative example - to be compared with inventive example 1 - wherein the crucible of configuration "C590" was filled up to 1 cm under cover (4) - see Fig. 4 in the present invention -, a value for the RCSR was calculated to be 0.43: although still providing a screen speed within the desired range and a good image quality, the preparation conditions were more critical with respect to reproducibility. Filling the crucible up to a level of 0.5 cm under cover (4) - see Fig. 4 in the present invention -, was detrimental with respect to screen speed and reproducibility. For these experiments a RCSR value exceeding 0.5 was calculated.
Same conclusions were drawn when filling the crucible of configuration "M15" up to a level more close to the first non-internal cover, as soon as RCSR values exceeding 0.5 were calculated. PARTS LIST
(1) folded crucible;
(2) the container of the crucible;
(3) a lip (present at both sides of the crucible);
(4) a cover plate with
(5) a slit;
(6) guiding plate;
(7) folded cover plate;
(8)and(8')level attained in crucible filled with raw materials

Having described in detail preferred embodiments of the current invention, it will now be apparent to those skilled in the art that numerous modifications can be made therein without departing from the scope of the invention as defined in the appending claims.■

## Claims

1. A method of consecutively manufacturing a set of at least 5 storage phosphor plates by a vapor deposition process in one and the same vapor deposition apparatus, wherein in said apparatus, before starting each vaporization, refractory material surfaces are brought into contact, in a crucible unit thereof, with liquefied raw materials of a matrix component and an activator component, a phosphor precursor component or a combination of matrix, activator and precursor component, wherein deviations in speed from one plate to another within said set of storage phosphor plates are less than 15 %, said deviations being expressed as a variation coefficient defined by following formula (SAL%dev/SAL%av) x 100, provided that SAL%av stands for an averaged speed within average speeds over each of said storage phosphor plate surfaces within said set and that SAL%dev stands for a standard deviation of averaged speeds obtained from each phosphor plate within said set, wherein a step of increasing said refractory material surfaces is included by adding to said crucible unit, before starting vaporization in the manufacturing of each of said plates in said set, refractory particles selected from the group consisting of a powder, crystalline particles, amorphous particles, spheres, bars, sticks, ingots and curls or a combination thereof.

2. Method according to claim 1, wherein in a set of up to 25 storage phosphor plates, deviations in speed from one plate to another within said set are less than 10 %, provided that particles added to a crucible unit in said apparatus are in form of a powder.

3. Method according to claim 1 or 2, wherein said refractory material surfaces are metals selected from the group consisting of Ta, Ti, Mo and W or a combination thereof.

4. Method according to claim 1 or 2, wherein said powder is tantalum powder.

5. Method according to any one of the claims 1 to 4, wherein refractory material surfaces, present as extended refractory material surfaces, besides said particles, comprise an optionally present extended chimney, cover(s), baffle plate(s), grid(s), grating(s), flap(s), shield(s) and/or heat-protecting screen(s); all additional refractory material parts within a crucible coming into contact with vaporized and/or liquefied raw materials and all additional parts present within a vapor deposition apparatus coming into contact with vaporized raw materials.

6. Method according to any one of the claims 1 to 5, wherein said method comprises a step of providing a refractory surface as a fresh or refreshed refractory surface before starting said vapor deposition process.

7. Method according to claim 6, wherein wherein a refreshed refractory surface is offered by removing corroded surface layers thereof, and wherein removing said layers proceeds by at least one or a combination of techniques selected from the group consisting of physically removing, chemically removing, electrochemically polishing, reactive ion treating, glow discharge treating, sandblasting, shot cleaning and ultrasonically treating.

8. Method according to any one of the claims 1 to 7, wherein said matrix component is represented by the formula (I) M¹X.aM²X'₂.bM³X"₃ (I) wherein
M¹ represents an alkali metal selected from the group consisting of Li, Na, K, Rb and Cs;
M² represents a divalent metal selected from the group consisting of Be, Mg, Ca, Sr, Ba, Zn, Cd, Cu and Ni;
M³ represents a trivalent metal selected from the group consisting of Sc, Y, La, Ce, Pr, Nd, Pm, Sm, Eu, Gd, Tb, Dy, Ho, Er, Tm, Yb, Lu, Al, Ga and In; X, X' and X" each represent a halogen selected from the group consisting of F, Cl, Br and I; a and b each represent 0 ≤ a < 0.5 and 0 ≤ b < 0.5.

9. Method according to any one of the claims 1 to 7, wherein said matrix component is CsX, wherein X represents Cl, Br, I or a combination thereof.

10. Method according to any one of the claims 1 to 9, wherein said activator component is represented by symbol A, being an element selected from the group consisting of Eu, Tb, Bi, In, Ga, Cs, Ce, Tm, Dy, Pr, Ho, Nd, Yb, Er, Gd, Lu, Sm, Y, Tl, Na, Ag, Cu and Mg.

11. Method according to any one of the claims 1 to 9, wherein said activator component is a halide salt, an oxide, a halide and/or oxy halide of said activator element.

12. Method according to any one of the claims 1 to 11, wherein said activator component is one of EuX₂, EuX₃, EuOX, wherein X represents Cl, Br, I or a combination thereof.

13. Method according to any one of the claims 1 to 11, wherein said precursor component CsₓEu_{y}X'_{(x+αy)}, wherein x, y and a are integers, wherein x/y is 0.25 or more, wherein α is at least 2 and wherein X' represents Cl, Br, I or a combination thereof.

14. Method according to any one of the claims 1 to 11, wherein said precursor component is selected from the group consisting of CsEu₄Br₉, CsEu₂Br₅, CsEuBr₃, Cs₂EuBr₄ and Cs₃EuBr₅.

15. Method according to any one of the claims 4 to 14, wherein said phosphor plate is non-colored and wherein tantalum is present in an amount of from 1 to 50 p.p.m.. ■
